# EUROPEAN PATENT APPLICATION

(11) **EP 2 632 235 A1**
(43) Date of publication of application: **28.08.2013**
(21) Application number: 12194579.4
(22) Date of filing: 28.11.2012
(51) Int. Cl.: H05K 1/02, H05K 1/11

(54) **Multilayer wiring board and electronic device**

(30) Priority: 21.02.2012 JP 2012035565
(71) Applicant: FUJITSU LIMITED, Kawasaki-shi, Kanagawa 211-8588 (JP)
(72) Inventor: Kawai, Kenichi, Kanagawa, 211-8588 (JP)
(74) Representative: HOFFMANN EITLE

(57) **Abstract**

A ground layer(2) of a multilayer wiring board (3) includes: a first clearance (141) through which a first differential via (30A) is inserted without coming into contact with the ground layer; and a second clearance (142) through which a second differential via (30B) is inserted without coming into contact with the ground layer. A distance(Rx) between an outer edge of the first clearance on the side of the second differential via and the first differential via is set shorter than a distance (Rmax) between an outer edge of the first clearance on the side opposite from the second differential via and the first differential via. A distance (Rx) between an outer edge of the second clearance on the side of the first differential via and the second differential via is set shorter than a distance (Rmax) between an outer edge of the second clearance on the side opposite from the first differential via and the second differential via.

## Description

### FIELD

The embodiments discussed herein are related to a multilayer wiring board and an electronic device.

### BACKGROUND

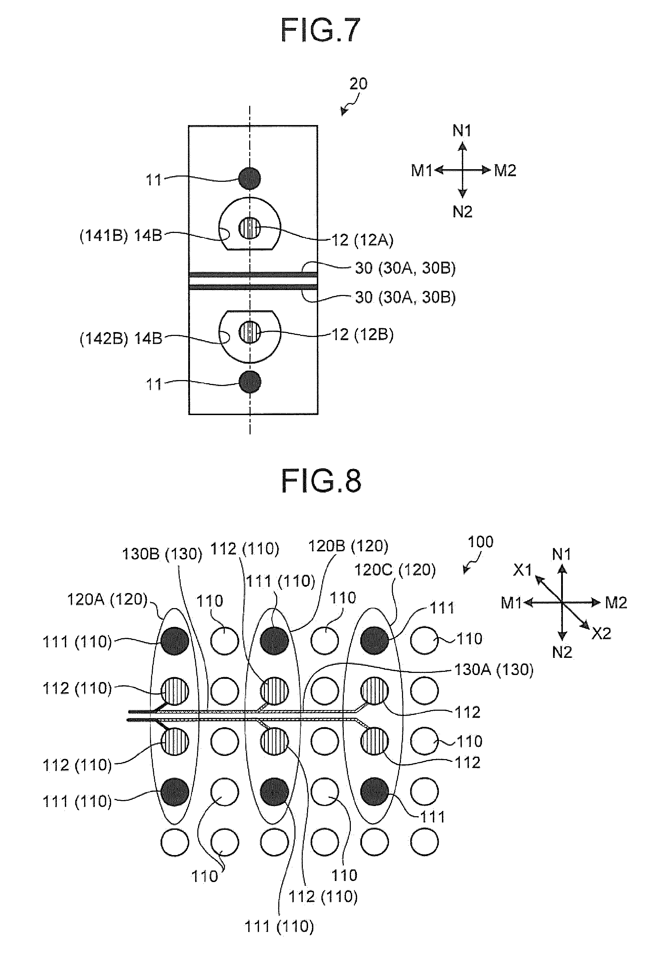

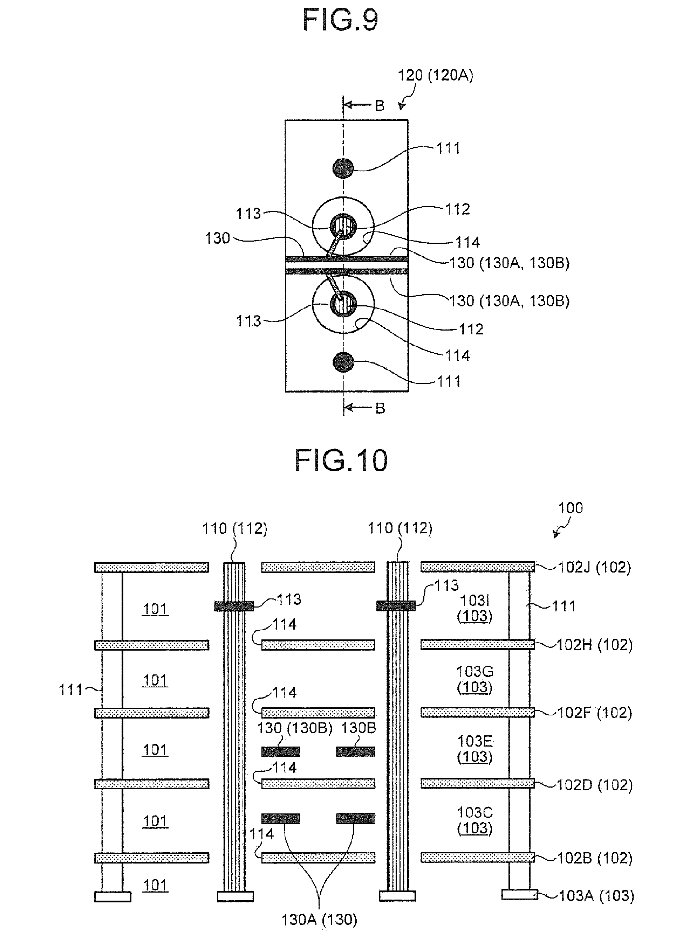

There has been a technology of connecting each layer in a multilayer wiring board by a via in the related art. FIG. 8 is an explanatory view illustrating an example of an arrangement relationship of signal via pairs in the multilayer wiring board with a part omitted, FIG. 9 is an explanatory view illustrating an example of the signal via pairs, and FIG. 10 is a cross-sectional view taken along line B-B of FIG. 9 with a part omitted.

A multilayer wiring board 100 illustrated in FIG. 10 has a multilayer structure formed by sequentially laminating a plurality of ground layers 102 and signal layers 103 by using an insulating material 101. For example, each layer is laminated on a first signal layer 103A of the multilayer wiring board 100 in the order of a second ground layer 102B, a third signal layer 103C, a fourth ground layer 102D, a fifth signal layer 103E, a sixth ground layer 102F, and a seventh signal layer 103G. Moreover, each of an eighth ground layer 102H, a ninth signal layer 103I, a tenth ground layer 102J and the like is laminated on the seventh signal layer 103G of the multilayer wiring board 100 in this order.

Vias 110 are formed on a laminating surface of the multilayer wiring board 100 in a grid pattern at a predetermined pitch by filling holes extending in a direction perpendicular to the laminating surface with a conductive substance such as copper. Each via 110 then connects each of the layers in the multilayer wiring board 100.

The plurality of vias 110 also includes a ground via 111 and a differential signal via 112. The ground via 111 is connected to the ground layer 102. The differential signal via 112 is connected to the signal layer 103 through a signal land 113. For the convenience of explanation, a black circle indicates the ground via 111 and a hatched circle indicates the differential signal via 112 in FIG. 8.

In addition, a signal via pair 120 includes, for example, a pair of the differential signal vias 112 adjacent in an N1 or an N2 direction as illustrated in FIG. 8, and a pair of the ground vias 111 that interposes the pair of differential signal vias 112 therebetween. Moreover, the signal via pair 120 is connected to a BGA (Ball Grid Array) or an LGA (Land Grid Array), for example. Each signal via pair 120 is disposed while being offset from the adjacent signal via pair 120 by one or two vias, for example.

Moreover, a clearance 114 with a diameter larger than that of the differential signal via 112 is formed in the ground layer 102 through which the differential signal visas 112 in the signal via pair 120 are inserted, the clearance 114 preventing a short circuit between the differential signal vias 112. The clearance 114 is formed in a position not in contact with the differential signal vias 112.

Furthermore, in the multilayer wiring board 100, a differential wiring 130 is disposed in a direction of drawing out a wiring, and this differential wiring 130 is used to draw out the wiring from the differential signal via 112 when the wiring is to be drawn out from the differential signal via 112 of the signal via pair 120.

The multilayer wiring board 100 illustrated in FIG. 8 includes a first to a third signal via pairs 120A to 120C, for example. The multilayer wiring board 100 includes a first differential wiring 130A that draws out a wiring from the differential signal via 112 of the third signal via pair 120C, and a second differential wiring 130B that draws out a wiring from the differential signal via 112 of the second signal via pair 120B. In addition, as illustrated in FIG. 10, the first differential wiring 130A is disposed in the third signal layer 103C between the second ground layer 102B and the fourth ground layer 102D and passes between the differential signal vias 112 in the first signal via pair 120A, for example. Moreover, the second differential wiring 130B is disposed in the fifth signal layer 103E between the fourth ground layer 102D and the sixth ground layer 102F and passes between the differential signal vias 112 in the first signal via pair 120A, for example.
Patent Document 1: Japanese Laid-open Patent Publication No. 60-127797
Patent Document 2: Japanese National Publication of International Patent Application No. 2010-506380
Patent Document 3: Japanese Laid-open Patent Publication No. 2011-18673
Patent Document 4: Japanese Laid-open Patent Publication No. 08-204338
Patent Document 5: Japanese Laid-open Patent Publication No. 2001-119154
Patent Document 6: Japanese Laid-open Patent Publication No. 2004-95614

Accompanying the request to increase the wiring density in recent years, a diameter of the differential signal via 112 in the signal via pair 120 of the multilayer wiring board 100 is approximately 0.25 mm as illustrated in FIG. 9, and thus the impedance value of the via portion does not meet the ideal value of, for example, 50 Ω as it stands.

Typically, the impedance value is inversely proportional to the one-half power of the capacity of a via and increases as the capacity decreases. Accordingly, as illustrated in FIGS. 9 and 10, the impedance value of the via portion has been increased by increasing the diameter of the clearance 114 of the ground layer 102 through which the differential signal via 112 is inserted and decreasing the capacity of the via portion of the differential signal via 112.

However, the surface area of the ground layer 102 would be decreased when the diameter of the clearance 114 of the ground layer 102 is increased. As a result, for example, the surface area of the fourth ground layer 102D between the first differential wiring 130A and the second differential wiring 130B would also be decreased, causing the greater crosstalk due to an electromagnetic wave between the first differential wiring 130A and the second differential wiring 130B. It is difficult to adjust the impedance of the via portion of the differential signal via 112 and suppress the crosstalk between the differential wirings 130 at the same time.

Accordingly, it is an object in one aspect of an embodiment of the invention to provide the multilayer wiring board and an electronic device capable of reducing the crosstalk between the differential wirings (the differential signal wirings) disposed in each signal layer between the ground layers.

### SUMMARY

According to an aspect of the embodiments, a multilayer wiring board includes: at least one signal layer; at least one ground layer; a first signal via that is connected to a pair of differential signal wirings provided on the signal layer and extends in a laminating direction of the multilayer wiring board; and a second signal via that is connected to the pair of differential signal wirings and extends in the laminating direction of the multilayer wiring board, wherein the ground layer includes: a first clearance through which the first signal via is inserted without coming into contact with a wiring of the ground layer; and a second clearance through which the second signal via is inserted without coming into contact with the wiring of the ground layer, a distance between an outer edge of the first clearance on a side of the second signal via and the first signal via is set shorter than a distance between an outer edge of the first clearance on a side opposite from the second signal via and the first signal via, and a distance between an outer edge of the second clearance on a side of the first signal via and the second signal via is set shorter than a distance between an outer edge of the second clearance on a side opposite from the first signal via and the second signal via.

### BRIEF DESCRIPTION OF DRAWINGS

FIG. 1 is an explanatory view illustrating an example of an arrangement relationship of signal via pairs of a multilayer wiring board with a part omitted;
FIG. 2 is an explanatory view illustrating an example of a signal via pair of Example 1;
FIG. 3 is a cross-sectional view taken along line A-A of FIG. 2 with a part omitted;
FIG. 4 is an explanatory view comparing calculation results of crosstalk of Example and Comparative Example 1;
FIG. 5 is an explanatory view illustrating an example of a signal via pair of Example 2;
FIG. 6 is an explanatory view comparing calculation results of crosstalk of Example 2 and Comparative Example 1;
FIG. 7 is an explanatory view illustrating an example of a signal via pair of Example 3;
FIG. 8 is an explanatory view illustrating an example of an arrangement relationship of signal via pairs of the multilayer wiring board with a part omitted;
FIG. 9 is an explanatory view illustrating an example of a signal via pair; and
FIG. 10 is a cross-sectional view taken along line B-B of FIG. 9 with a part omitted.

### DESCRIPTION OF EMBODIMENTS

Preferred embodiments of the present invention will be explained with reference to accompanying drawings.

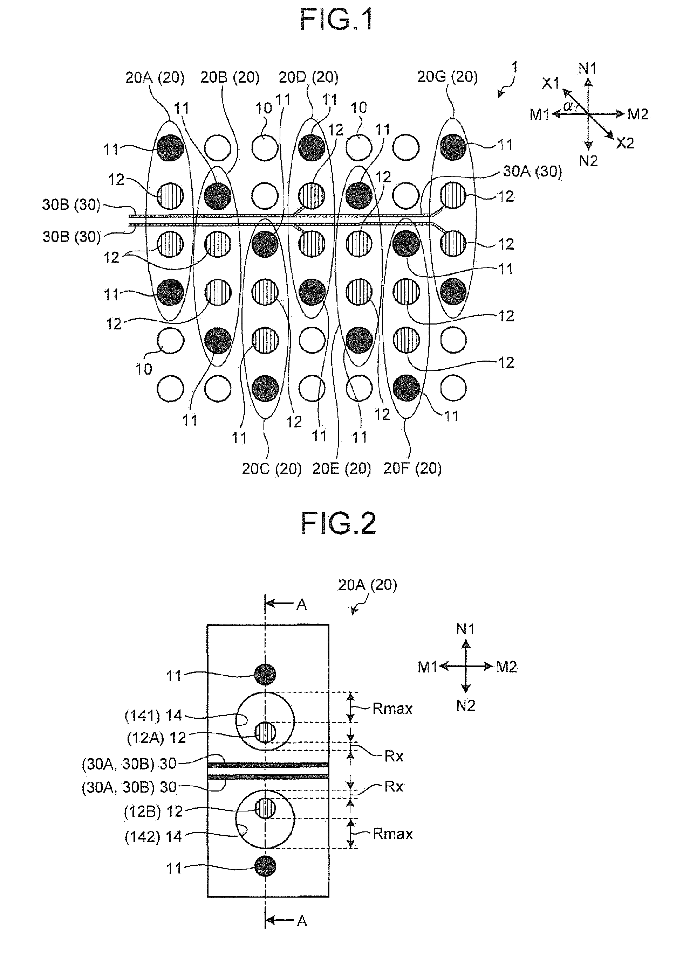

Note that the disclosed technology is not to be limited by the present Example. In Example below, two-dimensional relative positions of each element such as the vias in the multilayer wiring board are illustrated with a vertical direction indicated by the N1 and the N2 facing the figure and a horizontal direction indicated by an M1 and an M2 facing the figure as illustrated in FIG. 1, for example. In addition, a upper left direction and an lower right direction facing the figure are indicated by an X1 and an X2, respectively. An axis X1-X2 and an axis M1-M2 intersect at an angle α that is 0° < α ≤ 45°, for example.

In addition to the axis X1-X2, the two-dimensional relative positions of each element in the multilayer wiring board may also be specified by an axis that is line-symmetrical with the axis X1-X2 with respect to an axis N1-N2 and indicates the upper right and the lower left directions facing the figure in FIG. 1 and the like. In Example below, each element such as the signal vias in the multilayer wiring board is disposed in the grid pattern at the predetermined pitch in the M1 and the M2 directions as well as the N1 and the N2 directions. The X1 and the X2 directions would be diagonal to the predetermined pitch. Also, in Example below, the diameter of the differential signal via indicates the maximum diameter of a horizontal cross-section of the differential signal via. Moreover, the diameter of the clearance indicates the maximum diameter of a horizontal cross-section of the clearance.

### [a] Example 1

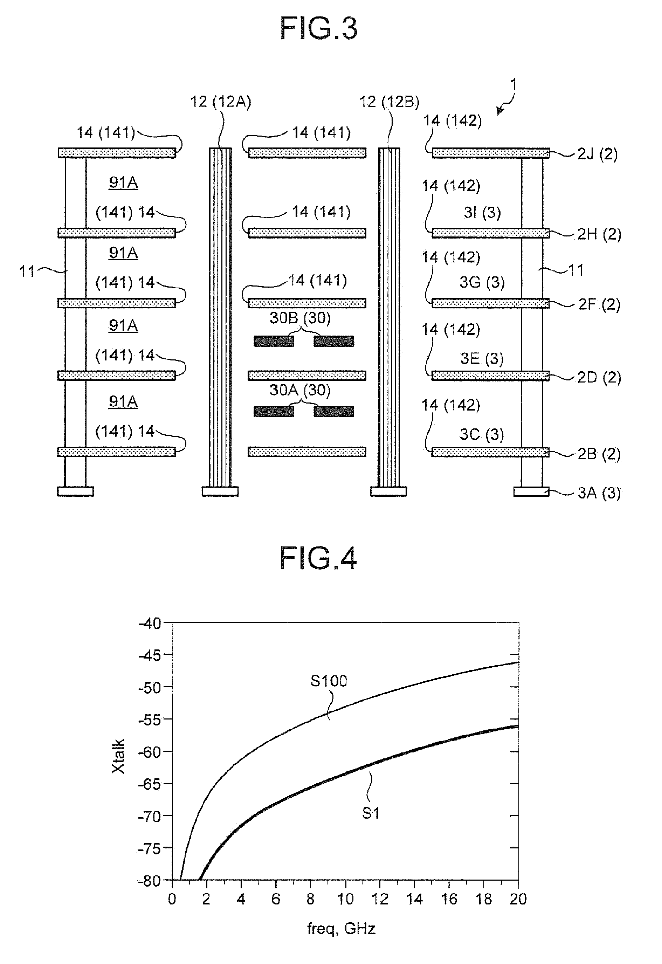

FIG. 1 is an explanatory view illustrating an example of an arrangement relationship of signal via pairs of a multilayer wiring board with a part omitted. FIG. 2 is an explanatory view illustrating an example of a signal via pair of Example 1. FIG. 3 is a cross-sectional view taken along line A-A of FIG. 2 with a part omitted.

A multilayer wiring board 1 illustrated in FIG. 3 has a multilayer structure such as an 18-layer structure formed by sequentially laminating a plurality of ground layers 2 and signal layers 3 by using an insulating material 91A. For example, each layer is laminated on a first signal layer 3A of the multilayer wiring board 1 in the order of a second ground layer 2B, a third signal layer 3C, a fourth ground layer 2D, a fifth signal layer 3E, a sixth ground layer 2F, and a seventh signal layer 3G. Moreover, each of an eighth ground layer 2H, a ninth signal layer 31, a tenth ground layer 2J and the like is laminated on the seventh signal layer 3G of the multilayer wiring board 1 in this order. For the convenience of explanation, illustrations from an eleventh layer to an eighteenth layer are omitted. The fourteenth layer, the sixteenth layer and the eighteenth layer are referred to as the signal layers 3, for example.

A via 10 is formed by filling a hole extending in a direction perpendicular to a laminating surface of the ground layer 2 and the signal layer 3 with a conductive substance such as copper. However, the hole does not have to be completely filled as long as the via is conducted to the layers connected. Also, the plurality of vias 10 is formed on the laminating surface in a grid pattern at a predetermined pitch, as illustrated in FIG. 1. Each of the layers in the multilayer wiring board 1 is then connected by each via 10.

Moreover, the plurality of vias 10 includes a ground via 11 and a differential signal via 12. The differential signal via 12 is an example of a signal via. The ground via 11 is connected to the ground layer 2. Also, the differential signal via 12 is connected to the signal layer 3 through a signal land 13 that is not represented. For the convenience of explanation, a black circle indicates the ground via 11 and a hatched circle indicates the differential signal via 12 in FIG. 1.

Furthermore, a signal via pair 20 includes, among the plurality of vias 10 disposed in the grid pattern: a pair of the differential signal vias 12 formed by a pair of the vias 10 adjacent in an N1 or an N2 direction illustrated in FIG. 1; and a pair of the ground vias 11 adjacent to the pair of differential signal vias 12. Formed by the vias 10 adjacent to the pair of differential signal vias 12 in the signal via pair 20, the pair of ground vias 11 in the signal via pair 20 can be changed as appropriate. Furthermore, the signal via pair 20 is connected to a BGA (Ball Grid Array) or an LGA (Land Grid Array), for example.

A differential wiring 30 is disposed in a direction of drawing out a wiring from the differential signal via 12, and this differential wiring 30 is used to draw out the wiring from the differential signal via 12 when the wiring is to be drawn out from the differential signal via 12 of the signal via pair 20. Note that the differential wiring 30 is an example of a signal wiring.

Furthermore, the multilayer wiring board 1 illustrated in FIG. 1 includes a first to a seventh signal via pairs 20A to 20G. The multilayer wiring board 1 includes a first differential wiring 30A that draws out a wiring from the differential signal via 12 of the seventh signal via pair 20G, and a second differential wiring 30B that draws out a wiring from the differential signal via 12 of the fourth signal via pair 20D. As illustrated in FIG. 3, the first differential wiring 30A is disposed in the third signal layer 3C between the second ground layer 2B and the fourth ground layer 2D and passes between the differential signal vias 12 in the first signal via pair 20A, for example. Moreover, the second differential wiring 30B is disposed in the fifth signal layer 3E between the fourth ground layer 2D and the sixth ground layer 2F and passes between the differential signal vias 12 in the first signal via pair 20A, for example.

Furthermore, a circular clearance 14 with a diameter larger than that of the differential signal via 12 is formed in the ground layer 2 through which the differential signal via 12 in the signal via pair 20 is inserted, the clearance 14 preventing a short circuit between the differential signal vias 12. The clearance 14 is formed in a position not in contact with the differential signal vias 12. As illustrated in FIG. 2, the clearance 14 is formed such that the center of diameter of the clearance 14 is offset in a direction away from the center of diameter of the differential signal via 12 and the differential wiring 30 and a direction in which the pair of differential signal vias 12 in the signal via pair 20 faces each other. The offset amount would be approximately 0.1 to 0.3 mm when a diameter of the via 10 is approximately 0.25 mm, a pitch between the vias 10 is approximately 1 mm, and a diameter of the clearance 14 is approximately 0.8 mm. The pitch between the vias 10 indicates a distance from the center of the via 10 to the center of the adjacent via 10.

The pair of differential signal vias 12 in the signal via pair 20 includes a first differential signal via 12A and a second differential signal via 12B. Also, the clearance 14 includes a first clearance 141 through which the first differential signal via 12A is inserted without coming into contact with the wiring of the ground layer 2, and a second clearance 142 through which the second differential signal via 12B is inserted without coming into contact with the wiring of the ground layer 2.

A distance Rx between an outer edge of the first clearance 141 on the side of the second differential signal via 12B and the first differential signal via 12A is set shorter than a distance Rmax between an outer edge of the first clearance 141 on the side opposite from the second differential signal via 12B and the first differential signal via 12A. A distance Rx between an outer edge of the second clearance 142 on the side of the first differential signal via 12A and the second differential signal via 12B is set shorter than a distance Rmax between an outer edge of the second clearance 142 on the side opposite from the first differential signal via 12A and the second differential signal via 12B.

The diameters of the first clearance 141 and the second clearance 142 are increased so that the capacity components of the via portions of the first differential signal via 12A and the second differential signal via 12B that are inserted through the first clearance 141 and the second clearance 142 are decreased. That is, the diameter of the clearance 14 is increased in order to decrease the capacity component of the via portion of the differential signal via 12 inserted through the clearance 14. Accordingly, the impedance value of the via portion of the differential signal via 12 can be increased.

Moreover, the diameter of the clearance 14 is increased and the center thereof is offset in a direction away from the differential wiring 30 without changing the position of the differential signal via 12. As a result, the surface area of the ground layer 2 on the differential wiring side 30 does not have to be decreased, thereby avoiding a situation where crosstalk between the differential wirings 30 is increased due to the increase in the diameter, the ground layer 2 being the fourth ground layer 2D between the first differential wiring 30A and the second differential wiring 30B, for example.

FIG. 4 is an explanatory view comparing calculation results of the crosstalk of Example 1 and Comparative Example 1. The calculation was performed where the diameter of the via 10 is approximately 0.25 mm, the diameter of the differential signal via 12 is approximately 0.2 mm, the pitch between the vias 10 is approximately 1 mm, the diameter of the clearance 14 is approximately 0.8 mm, the copper thickness of the signal layer 3 is 30 µm, and the thickness of the ground layer 2 is 0 as the ideal ground. The offset amount of the clearance 14 was set to approximately 0.2 mm.

An S-parameter of a mixed mode, in which a differential mode and a common mode are mixed, is used for the crosstalk. In addition, a substrate with the offset amount of the clearance 14 of approximately 0 mm is used in Comparative Example 1.

FIG. 4 illustrates the calculation results of the crosstalk between the first differential wiring 30A and the second differential wiring 30B. Crosstalk S1 between the first differential wiring 30A and the second differential wiring 30B of Example 1 is lower by approximately 10 dB than crosstalk S100 between the first differential wiring 30A and the second differential wiring 30B of Comparative Example 1 in nearly all frequency bands.

In Example 1, the diameters of the first clearance 141 and the second clearance 142 have been increased in order to decrease the capacity components of the via portions of the first differential signal via 12A and the second differential signal via 12B that are inserted through the first clearance 141 and the second clearance 142. That is, in Example 1, the diameter of the clearance 14 of the ground layer 2 has been increased to decrease the capacity component of the via portion of the differential signal via 12 inserted through the clearance 14. As a result, the impedance value of the via portion of the differential signal via 12 can be increased.

Moreover, the center of the clearance 14 has been offset in a direction away from the differential wiring 30 without changing the placement position of the differential signal via 12 even when the diameter of the clearance 14 is increased. As a result, the area of the ground layer 2 on the differential wiring 30 side can be secured to prevent the increase in the crosstalk between the differential wirings 30 due to the increase in the diameter, the ground layer 2 being a part of the fourth ground layer 2D between the first differential wiring 30A and the second differential wiring 30B facing each other, for example.

In Example 1 above, the center of the clearance 14 has been offset in a direction, the N1 or the N2 direction, for example, in which the pair of adjacent differential signal vias 12 faces each other. However, the center of the clearance 14 may also be offset diagonally to the N1 or the N2 direction. Such an embodiment will be described below as Example 2.

### [b] Example 2

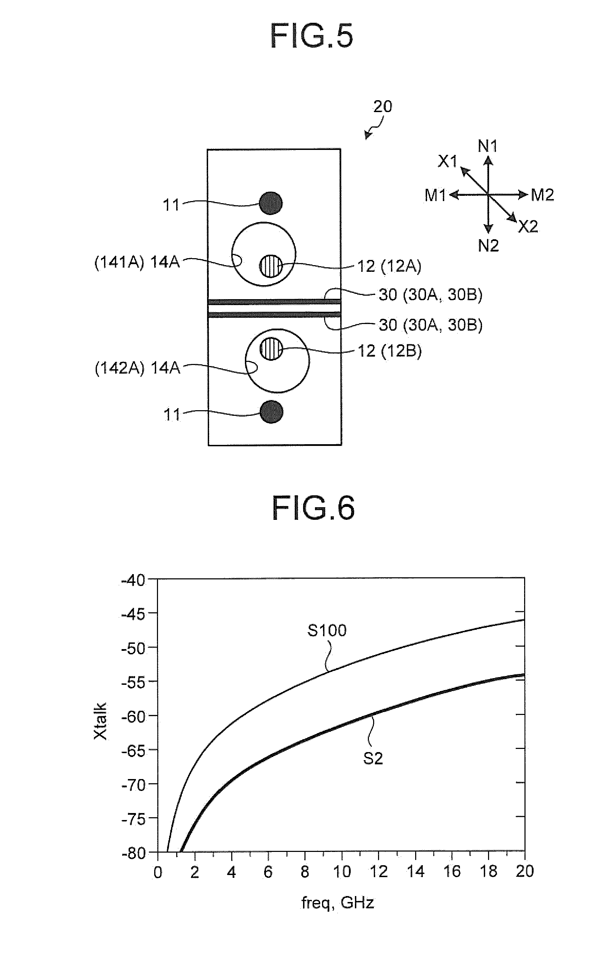

FIG. 5 is an explanatory view illustrating an example of a signal via pair of Example 2. Note that components identical to those of the multilayer wiring board 1 of Example 1 are assigned the same reference numerals so that descriptions for the overlapping structure and operation will be omitted.

The center of a clearance 14A of a signal via pair 20 illustrated in FIG. 5 has been offset in a direction away from a first differential wiring 30A and a second differential wiring 30B as well as an X1 or an X2 direction with respect to an N1 or an N2 direction.

A pair of differential signal vias 12 in the signal via pair 20 includes a first differential signal via 12A and a second differential signal via 12B. The clearance 14A includes a first clearance 141A through which the first differential signal via 12A is inserted without coming into contact with a wiring of a ground layer 2, and a second clearance 142A through which the second differential signal via 12B is inserted without coming into contact with a wiring of the ground layer 2.

The diameters of the first clearance 141A and the second clearance 142A have been increased in order to decrease the capacity of the via portions of the first differential signal via 12A and the second differential signal via 12B that are inserted through the first clearance 141A and the second clearance 142A. That is, the diameter of the clearance 14A has been increased in order to decrease the capacity of the via portion of the differential signal via 12 inserted through the clearance 14A. As a result, the impedance value of the via portion of the differential signal via 12 can be increased.

Moreover, the center of the clearance 14A has been offset in a direction away from a differential wiring 30 without changing the placement position of the differential signal via 12 even when the diameter of the clearance 14A has been increased. As a result, the surface area of the ground layer 2 on the differential wiring side 30 does not have to be decreased, thereby avoiding a situation where crosstalk between the differential wirings 30 is increased due to the increase in the diameter, the ground layer 2 being a fourth ground layer 2D between the first differential wiring 30A and the second differential wiring 30B, for example.

Referring now to FIG. 6, crosstalk S2 between the first differential wiring 30A and the second differential wiring 30B of Example 2 is lower by a little less than approximately 10 dB than crosstalk S100 between the first differential wiring 30A and the second differential wiring 30B of Comparative Example 1 in nearly all frequency bands.

In Example 2, the diameters of the first clearance 141A and the second clearance 142A have been increased so as to decrease the capacity of the via portions of the first differential signal via 12A and the second differential signal via 12B that are inserted through the first clearance 141A and the second clearance 142A. That is, in Example 2, the diameter of the clearance 14A of the ground layer 2 has been increased in order to decrease the capacity of the via portion of the differential signal via 12 inserted through the clearance 14A. As a result, the impedance value of the via portion of the differential signal via 12 can be increased.

Moreover, the center of the clearance 14A has been offset in a direction away from the differential wiring 30 without changing the placement position of the differential signal via 12 even when the diameter of the clearance 14A has been increased. As a result, the area of the ground layer 2 on the differential wiring 30 side can be secured to prevent the increase in the crosstalk between the differential wirings 30 due to the increase in the diameter, the ground layer 2 being a part of the fourth ground layer 2D between the first differential wiring 30A and the second differential wiring 30B facing each other, for example.

Illustrated in Example 1 above is the circular clearance 14, the center of which is offset in the direction such as the N1 or the N2 direction in which the pair of adjacent differential signal vias 12 faces each other. However, the planar shape of the clearance 14 may also be non-circular. Such an embodiment will be described below as Example 3.

### Example 3

FIG. 7 is an explanatory view illustrating an example of a signal via pair of Example 3. Note that components identical to those of the multilayer wiring board 1 of Example 1 are assigned the same reference numerals so that descriptions for the overlapping structure and operation will be omitted.

A clearance 14B of a signal via pair 20 illustrated in FIG. 7 has a non-circular shape in which a ground layer 2 on the side adjacent to a first differential wiring 30A and a second differential wiring 30B is kept and an opening area on the side opposite from the side adjacent to the first differential wiring 30A and the second differential wiring 30B is made large.

A pair of differential signal vias 12 in the signal via pair 20 includes a first differential signal via 12A and a second differential signal via 12B. The clearance 14B includes a first clearance 141B through which the first differential signal via 12A is inserted without coming into contact with a wiring of the ground layer 2, and a second clearance 142B through which the second differential signal via 12B is inserted without coming into contact with a wiring of the ground layer 2.

The opening areas of the first clearance 141B and the second clearance 142B have been made large, so that the capacity of the via portions of the first differential signal via 12A and the second differential signal via 12B that are inserted through the first clearance 141B and the second clearance 142B has been decreased. That is, the opening area of the clearance 14B has been made large in order to decrease the capacity of the via portion of the differential signal via 12 inserted through the clearance 14B. As a result, the impedance value of the via portion of the differential signal via 12 can be increased.

Moreover, the opening area of the clearance 14B has been made large by keeping the ground layer 2 on the side adjacent to the differential wiring 30 and increasing the opening area on the side opposite from the side adjacent to the differential wiring 30, without changing the placement position of the differential signal via 12. As a result, the surface area of the ground layer 2 on the differential wiring side 30 does not have to be decreased, thereby avoiding a situation where crosstalk between the differential wirings 30 is increased due to the increase in the opening area, the ground layer 2 being a fourth ground layer 2D between the first differential wiring 30A and the second differential wiring 30B, for example.

In Example 3, the opening areas of the first clearance 141B and the second clearance 142B are made large, so that the capacity of the via portions of the first differential signal via 12A and the second differential signal via 12B that are inserted through the first clearance 141B and the second clearance 142B is decreased. That is, in Example 3, the opening area of the clearance 14B of the ground layer 2 is made large in order to decrease the capacity of the via portion of the differential signal via 12 inserted through the clearance 14B. As a result, the impedance value of the via portion of the differential signal via 12 can be increased.

Moreover, the center of the clearance 14B has been offset in a direction away from the differential wiring 30 without changing the placement position of the differential signal via 12 even when the diameter of the clearance 14B has been increased. As a result, the area of the ground layer 2 on the differential wiring 30 side can be secured to prevent the increase in the crosstalk between the differential wirings 30 due to the increase in the opening area, the ground layer 2 being a part of the fourth ground layer 2D between the first differential wiring 30A and the second differential wiring 30B facing each other, for example.

Described in above Example is the multilayer wiring board 1, but a pad of a semiconductor unit such as a CPU may also be electrically connected to the signal via pair 20 of the multilayer wiring board 1 by a solder ball to provide an electronic device mounted with the semiconductor unit.

In above Example, the pair of differential signal vias 12 in the signal via pair 20 is formed by the pair of vias 10 adjacent in the N1 or the N2 direction among the plurality of vias 10 disposed in the grid pattern at the predetermined pitch. However, the pair of differential signal vias 12 may also be formed by the pair of vias 10 adjacent in the M1 or the M2 direction, or the X1 or the X2 direction.

Moreover, in Example 3, the planar shape of the clearance 14 is made non-circular but is not limited to the shape illustrated in FIG. 7.

Furthermore, the specific numerical values in above Examples are given by way of example, but not of limitation.

In one aspect, the crosstalk between the differential signal wirings disposed in each signal layer between the ground layers can be reduced.

## Claims

1. A multilayer wiring board (1) comprising:
at least one signal layer (3);
at least one ground layer (2);
a first signal via (12A) that is connected to a pair of differential signal wirings (30) provided on the signal layer and extends in a laminating direction of the multilayer wiring board; and
a second signal via (12B) that is connected to the pair of differential signal wirings and extends in the laminating direction of the multilayer wiring board,
wherein the ground layer includes:
a first clearance (141) through which the first signal via is inserted without coming into contact with a wiring of the ground layer; and
a second clearance (142) through which the second signal via is inserted without coming into contact with the wiring of the ground layer,
a distance (RX) between an outer edge of the first clearance (141) on a side of the second signal via and the first signal via is set shorter than a distance (Rmax) between an outer edge of the first clearance on a side opposite from the second signal via and the first signal via, and
a distance (RX) between an outer edge of the second clearance on a side of the first signal via and the second signal via is set shorter than a distance (Rmax) between an outer edge of the second clearance on a side opposite from the first signal via and the second signal via.

2. The multilayer wiring board according to claim 1, wherein the first clearance (141A) is formed deviating from a center side of the first signal via, and the second clearance (142A) is formed deviating from a center side of the second signal via.

3. The multilayer wiring board according to claim 2, wherein the outer edges of the first clearance (141,141A) and the second clearance (142,142A) are respectively formed in a circular shape.

4. The multilayer wiring board according to claim 2, wherein the outer edges of the first clearance (141B) and the second clearance (142B) are non-circular.

5. An electronic device comprising:
a multilayer wiring board (1); and
a semiconductor component that is mounted on the multilayer wiring board,
wherein the multilayer wiring board includes:
at least one signal layer (3);
at least one ground layer (2);
a first signal via (12A) that is connected to a pair of differential signal wirings (30) provided on the signal layer and extends in a laminating direction of the multilayer wiring board; and
a second signal via (12B) that is connected to the pair of differential signal wirings and extends in the laminating direction of the multilayer wiring board,
the ground layer includes:
a first clearance (141) through which the first signal via is inserted without coming into contact with a wiring of the ground layer; and
a second clearance (142) through which the second signal via is inserted without coming into contact with the wiring of the ground layer,
a distance (Rx) between an outer edge of the first clearance on a side of the second signal via and the first signal via is set shorter than a distance (Rmax) between an outer edge of the first clearance on a side opposite from the second signal via and the first signal via, and
a distance (Rx) between an outer edge of the second clearance on a side of the first signal via and the second signal via is set shorter than a distance (Rmax) between an outer edge of the second clearance on a side opposite from the first signal via and the second signal via.
